# EUROPÄISCHE PATENTANMELDUNG

(11) **EP 0 734 067 A2**
(43) Veröffentlichungstag der Anmeldung: **25.09.1996**
(21) Anmeldenummer: 96103063.2
(22) Anmeldetag: 29.02.1996
(51) Int. Cl.: H01L 27/02

(54) **Verfahren zum Herstellen einer CMOS-Struktur mit ESD-Schutz**

(30) Priorität: 24.03.1995 DE 19510777
(71) Anmelder: Deutsche ITT Industries GmbH, 79108 Freiburg (DE)
(72) Erfinder: Wilmsmeyer,Klaus, Dr.rer.nat.Dipl.-Ing., D-79211 Denzlingen (DE)

(57) **Zusammenfassung**

Die Erfindung betrifft ein Verfahren zum Herstellen einer CMOS-Struktur mit ESD-Schutz. Auf die Außentransistoren wird eine Schutz-Oxidschicht 13 aufgebracht, die so maskiert ist, daß die an die Feldoxid-Bereiche 6 und die Gatebereiche 8 angrenzenden Gebiete der jeweiligen Source- und Drain-Bereiche 10, 11 abgedeckt sind, die Schutzoxidschicht 13 einer Wärmebehandlung ausgesetzt wird und danach eine Silizierung stattfindet.

## Beschreibung

Die Erfindung betrifft ein Verfahren zum Herstellen einer CMOS-Struktur (komplementäre Isolierschicht-Feldeffekttransistor-Struktur) mit ESD-Schutz (Schutz gegen elektrostatische Überlastung) mit denen Merkmalen des Oberbegriffs des Patentanspruchs 1.

Ein solches Verfahren ist aus der US 5 262 344 bekannt.

Bei einer derartigen CMOS-Struktur ist der ESD-Schutz sehr wichtig, da dort auch die Source- und Drainbereiche der Außentransistoren der Integrierten Schaltung (IC) siliziert sind. Dies führt dazu, daß diese Source- und Drainbereiche einen sehr niedrigen elektrischen Widerstand aufweisen. In den an die Feldoxid- bzw. die Gatebereiche, einschließlich der Spacer, anstoßenden Gebieten der jeweiligen Source- und Drainbereiche können sehr hohe Feldstärken entstehen. Durch Ladungsträgermultiplikationen können dann dort Strompfade entstehen, die wegen des geringen Vorwiderstandes der silizierten Zuleitungen zu einer Zerstörung des Bauelements fuhren können. Die Ein- und Ausgangstransistoren sind davon besonders betroffen, da dort oft hohe Aufladungsspannungen von ca. 1000 V entstehen. Zur Vermeidung solcher Strompfade wird ein SALICIDE-Prozeß durchgeführt. Hierzu werden bei den Außentransistoren (Ausgangs-, Eingangs-, Schutz-Transistoren) die an die Feldoxidbereiche und die Spacer der Gatebereiche angrenzenden Gebiete der jeweiligen Source- und Drainbereiche durch eine Schutzoxidschicht vor dem Silizieren geschützt. Diese ist relativ dünn und wird mittels eines CVD-Verfahrens abgeschieden und mit einer ESD-Maske geeignet strukturiert, so daß eine maskierte bzw. maskierende Schutzoxidschicht entsteht. Die Ausbildung der maskierende Schutzoxidschicht erfolgt üblicherweise mittels eines Photoprozesses und anschließendem Ätzen. Die Schaltungsteile des IC's, die nicht unmittelbar mit der Außenwelt in Verbindung stehen, was i.a. für den größten Teil des IC's der Fall ist, müssen nicht direkt geschützt werden. Von diesen wird daher beim Ätzen die Schutzoxidschicht vollständig entfernt. Für Einzelheiten zu den übrigen Verfahrensschritten zum Herstellen der CMOS-Struktur werden soweit sie in den Einzelheiten nicht beschrieben sind, übliche, dem Fachmann bekannte Verfahrensschritte vorgenommen.

Bei einem solchen Verfahren entsteht das Problem, daß die maskierende Schutzoxidschicht auf anderen Oxiden, nämlich dem Feld- und Spacer-Oxid aufgebracht ist und von diesem, insbesondere im Innenteil der IC's durch Ätzung wieder entfernt wird. Dabei sollen das Feld- und das Spacer-Oxid möglichst unangetastet bleiben, da sich sonst die Anordnungs- und Schaltungsparameter des IC's ändern.

Der Erfindung liegt die Aufgabe zugrunde, das gattungsgemäße Verfahren dahingehend zu verbessern, daß die Schaltungsparameter der Vorrichtung nicht verändert werden und ein sicherer ESD-Schutz gewahrt bleibt.

Diese Aufgabe wird durch ein Verfahren mit den Merkmalen des Patentanspruchs 1 gelöst.

Eine bessere Ätzbarkeit der Schutzoxidschicht im Vergleich zu der Ätzbarkeit der Feldoxidbereiche und der an die Gatebereiche angrenzenden Spacer ist für einen selektiven Ätzprozeß bei der Maskierung der Schutzoxidschicht erforderlich, damit die entsprechenden Feldoxidbereiche und Spacer insbesondere im Innenteil des IC's möglichst wenig beschädigt werden. Eine genügend große Selektivität für diese Ätzung weisen beispielsweise CVD-Oxide auf. Das Silizieren erfolgt beispielsweise durch Sputtern von Metall, wie Titan und anschließendem Reaktions-Annealing. Bei der Verwendung von Schutzoxidschichten mit starker Ätzbarkeit, insbesondere bei CVD-Oxidschichten, ohne Wärmebehandlung wurde ein Übersilizieren beobachtet. Das Übersilizieren zeigt sich an den Rändern der Schutzoxidschicht; es treten dort Silizid-Spitzen auf, die sich in den geschützten Gebieten der Source- und Drainbereiche ausbilden. Solche Spitzen können insbesondere bei kleinen Strukturen zu sehr hohen elektrischen Feldstärken führen, wodurch der ESD-Schutz reduziert würde. Dadurch, daß die maskierte Oxidschicht vor dem Silizieren einer Wärmebehandlung ausgesetzt und dadurch "verdichtet" wird, d.h. daß ihre Ätzbarkeit verringert wird, kann dieses Übersilizieren über die Schutzoxid-Ränder hinaus gemäß der Erfindung verhindert werden, und es entstehen glatte Silizidränder.

Gemäß einem vorteilhaften Ausführungsbeispiel der Erfindung ist die Wärmebehandlung ein Puls-Annealing-Verfahren bei einer Temperatur zwischen 800 und 900° C, insbesondere 875° C , und in einem Zeitintervall von 20 sec. bis 5 min., insbesondere 3min.. Unter diesen Bedingungen werden besonders glatte Silizidränder erreicht. Es ist günstig, wenn das Verhältnis der Ätzrate der Schutzoxidschicht zu der Ätzrate des Feldoxids bzw. Spaceroxids 20 zu 1 beträgt. Ferner ist es vorteilhaft, wenn die maskierende Oxidschicht eine Dicke von mehr als 20 nm aufweist.

Im folgenden wird die Erfindung anhand der Zeichnung näher erläutert.

Es zeigen:
Fig. 1 ein Ausführungsbeispiel einer nach dem erfindungsgemäßen Verfahren hergestellten CMOS-Struktur nach dem Ätzen der Schutzoxidschicht und
Fig. 2 die CMOS-Struktur gemäß Fig. 1 nach dem Silizieren.

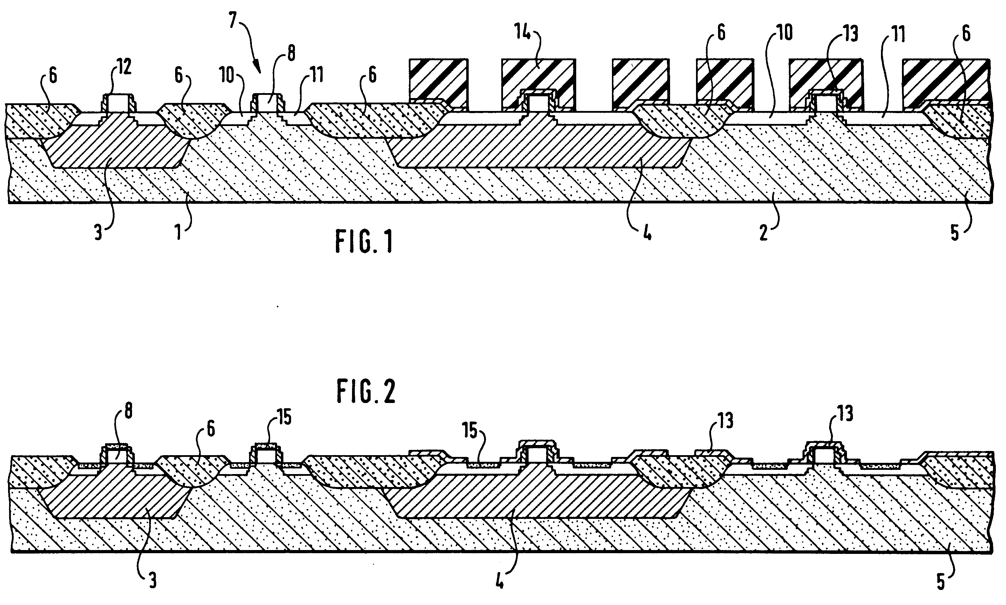

In Fig. 1 ist ein Ausschnitt aus einer CMOS-Struktur gezeigt, die ein Innenteil 1 und ein Randteil 2 aufweist. Das Verfahren ist soweit durchgeführt, daß sowohl in dem Innenteil 1 als auch in dem Randteil 2 Wannenbereiche 3 bzw. 4 ausgebildet sind. Es wird als Beispiel angenommen, daß es sich bei dem Substrat 5 um ein p-dotiertes Siliziumsubstrat handelt. Dann sind die Wannenbereiche 3 und 4 n-dotiert. Ferner sind sowohl im Innenteil 1 als auch im Randteil 2 Feldoxidbereiche 6 ausgebildet. Ferner sind Feldeffekttransistoren 7 mit einem Gate 8, das üblicherweise aus Polysilizium besteht, und dazugehörendem Source-Bereich 10 und Drain-Bereich 11 vorgesehen. Ferner sind Spacer 12 aus Silizium-Oxid ausgebildet, die verhindern, daß die hohe Dotierung für den Source-Bereich 10 und den Drain-Bereich 11 unter das Gate 8 gelangen.

In dem Randteil 2 des IC's ist eine maskierende Schutzoxidschicht 13 für die danachfolgende Silizierung ausgebildet. Die Schutzoxidschicht 13 wird dadurch erzeugt, daß mit einem CVD-Verfahren ein relativ dünnes Schutzoxid auf die CMOS-Struktur aufgebracht wird und mit einer ESD-Maske strukturiert wird. Die Strukturierung geschieht üblicherweise mittels eines Photoprozesses und anschließendem Ätzen. Die hierzu erforderliche Photolackschicht 14 ist in Fig. 1 dargestellt. Die Schutzoxydschicht 13 ist so maskiert, daß von den Außentransistoren, d.h. von den Transistoren 7 im Randteil 2 des IC's, die an die Feldoxidbereiche 6 und die Gatebereiche 8 angrenzenden Gebiete der jeweiligen Source-Bereiche 10 und Drain-Bereiche 11 sowie die Feldoxidbereiche 6 und die Gatebereiche 8 einschließlich der Spacer 12 abgedeckt sind. Danach findet ein Silizieren der CMOS-Struktur statt. Das dabei verwendete Metall, z.B. Titan reagiert mit Silizium, nicht aber mit Siliziumoxid. Es entstehen damit überall dort, wo das Silizium nicht mit Siliziumoxid bedeckt ist, silizierte Bereiche 15, wie man Fig. 2 entnimmt. Im Randteil 2 des IC's werden somit die inneren Gebiete der Source-Bereiche 10 und der Drain-Bereiche 11 siliziert. Im Innenteil des IC's werden die gesamten Source-Bereiche 10, Drainbereiche 11 und die Gatebereiche 8 siliziert. Durch die Silizierung der Transistoren 7 im Innenteil 1 werden niedrige Widerstände der entsprechenden Anschlüsse erreicht, was zu schnelleren Transistoren führt. Dort ist ein ESD-Schutz nicht erforderlich, da im Innenteil 1 des IC's keine großen Spannungen auftreten; die Spannungen betragen dort üblicherweise bis zu 5 V. Im Randteil 2 des IC's sind die Transistoren 7 als Außentransistoren gefährdet, da dort hohe Spannungen in der Größenordnung von 1000 V auftreten können. Dort werden daher nur die inneren Gebiete der Source-Bereiche 10 und der Drain-Bereiche 11 der jeweiligen Transistoren 7 siliziert. Für die Schutzoxidschicht 13 wird ein CVD-Oxid verwendet, das gegenüber den für die Feldoxidbereiche 6 und die Spacer 12 verwendeten Oxiden eine große Ätzselektivität aufweist. Letzteres wird durch verschiedene Ätzraten der Oxide erreicht. Typischerweise beträgt das Verhältnis der Ätzrate der Schutzoxidschicht zu der des Feldoxids und des Spaceroxids 20 zu 1. Die Dicke der Schutzoxidschicht 13 beträgt einige zehn nm. Vor dem Silizieren, also beispielsweise vor dem Sputtern von Titan, wird die Schutzoxidschicht einer Hochtemperaturbehandlung, beispielsweise einem Puls-Annealing-Verfahren ausgesetzt. Dabei wird die Schutzoxidschicht 13 verdichtet bzw. ihre Ätzbarkeit verringert. Es wird hierzu beispielsweise eine Temperatur zwischen 800 und 900° C und ein Zeitintervall von 20 sec. bis 5 min. gewählt. Durch diese Temperaturbehandlung wird die "lose Struktur" des Schutzoxids so verändert, daß beim anschließenden Silizieren die Selektivität der Silicidbildung, d.h. nur auf dem freiliegenden Silizium, voll gewahrt bleibt und ein Übersilizieren über die Ränder der Schutzoxidschicht 13 verhindert wird. Ohne diese "Verdichtung" bzw. Änderung der Ätzrate aufgrund der Temperaturbehandlung wird zwar die Silizierung auf dem größten Teil des unter der Schutzoxidschicht 13 liegenden Siliziums verhindert, jedoch würde an den Rändern der Schutzoxidschicht 13 jeweils ein Übersilizieren stattfinden. Dabei können sich Silizidspitzen ausbilden, die sich in das geschützte Gebiet erstrecken. Insbesondere bei kleinen CD (critical dimension)-Maßen entsteht dadurch die Gefahr hoher elektrischer Feldstärken an den Spitzen, so daß der ESD-Schutz beträchtlich reduziert würde. Aufgrund des Verdichtungsprozesses wird jedoch das Silizieren über die Ränder der Schutzoxidschicht verhindert, so daß glatte Silizidränder entstehen.

## Patentansprüche

1. Verfahren zum Herstellen einer CMOS-Struktur mit ESD-Schutz (Schutz gegen elektrostatische Überlastung), bei dem in einem Substrat (5) eines ersten Leitungstyps wenigstens ein Wannenbereich (3, 4) eines zweiten zu dem ersten entgegengesetzten Leitungstyps ausgebildet wird, Feldoxidbereiche (6), Gate-Oxidbereiche (8) mit jeweils einer Gateelektrode und an die Gateelektrode angrenzende Spacer (12) erzeugt werden, zu den jeweiligen Gate-Oxidbereichen (8) gehörende Source- und Drain-Bereiche (10, 11), die im Substrat (5) vom zweiten Leitungstyp und im Wannenbereich (3, 4) vom ersten Leitungstyp sind, ausgebildet werden und Transistoren bilden, bei dem eine Schutzoxidschicht (13) aufgebracht wird, welche so maskiert wird, daß von Außentransistoren (7) im Randteil (2) der CMOS-Struktur die an die Feldoxidbereiche (6) und die Gatebereiche (8) angrenzenden Gebiete der jeweiligen Source- und Drain-Bereiche (10, 11), die Gatebereiche (8), die Spacer (12) sowie wenigstens die an die Source- und Drain-Bereiche (10, 11) angrenzenden Gebiete der Feldoxidbereiche (6) abgedeckt sind, und bei dem die mit der Schutzoxidschicht (13) versehene Struktur siliziert wird,
**dadurch gekennzeichnet**, daß die Schutzoxidschicht (13) eine größere Ätzrate als die Ätzrate der Feldoxidbereiche (6) und der Spacer (12) aufweist und vor dem Silizieren einer Wärmebehandlung ausgesetzt wird, wobei die Parameter so gewählt sind, daß die Ätzrate der Schutzoxidschicht (13) durch die Wärmebehandlung verkleinert wird.

2. Verfahren nach Anspruch 1, dadurch gekennzeichnet, daß als Wärmebehandlung ein Puls-Annealing-Verfahren bei einer Temperatur zwischen 800° C und 900° C, insbesondere 875° C, und in einem Zeitintervall von 20 sec. bis 5 min., insbesondere 3 min., durchgeführt wird.

3. Verfahren nach Anspruch 1 oder 2, dadurch gekennzeichnet, daß das Verhältnis der Ätzrate der Schutzoxidschicht (13) vor der Wärmebehandlung zu der Ätzrate der Feldoxidbereich der Spacer 20: 1 beträgt.

4. Verfahren nach einem der vorangehenden Ansprüche, dadurch gekennzeichnet, daß die Dicke der Schutzoxidschicht (13) größer als 20 nm ist.
